(19) Europäisches Patentamt
European Patent Office
Office européen des brevets

(11) **EP 2 093 849 A2**

(12) **EUROPEAN PATENT APPLICATION**

(43) Date of publication:
**26.08.2009 Bulletin 2009/35**

(51) Int Cl.:
**H01S 5/0683** (2006.01)  **H01S 5/042** (2006.01)

(21) Application number: **09153000.6**

(22) Date of filing: **17.02.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **21.02.2008 JP 2008040211**

(71) Applicant: **Fujitsu Limited**
**Kawasaki-shi, Kanagawa 211-8588 (JP)**

(72) Inventors:
• **Takahashi, Kensuke**
  **Kanagawa 211-8588 (JP)**
• **Sakuramoto, Shinichi**
  **Kanagawa 211-8588 (JP)**

(74) Representative: **HOFFMANN EITLE**
**Patent- und Rechtsanwälte**
**Arabellastrasse 4**
**81925 München (DE)**

(54) **Optical transmitter**

(57)     A optical transmitter includes a light device provided a driving current and for emitting light on the bases of the driving current; a light measure for measuring an output light level of the light device; a controller for controlling the driving current to the light device and for changing the measured output light power level into a set output light power level of the light device; a current measure for measuring a level of the driving current to the light device; an abnormality detector for detecting an aged deterioration of the light device on the bases of the current level of the driving current by the current measure and the measured output light power level by the light measure; and an adjuster for reducing the set output light power level in the controller when the abnormality detector detects the aged deterioration of the light device.

Fig. 1

EP 2 093 849 A2

**Description**

FIELD

The present invention relates to an optical transmitter and control method that control the level of an optical signal to be transmitted.

BACKGROUND

In recent years, many optical transmission apparatus are used in various places such as transport-related places and access-related places due to the spread of the Internet. For that reason, optical communication equipment that can satisfy a temperature condition in a wide range has been demanded, and the suppression of increases in temperature becomes important. Particularly in an optical transmitter, the temperature tolerance of the optical transmitter depends on how increases in temperature of light emitting devices are suppressed.

In an optical transmitter, Auto Power Control (APC) that controls the level of an optical signal to be transmitted is applied. In APC, the level of output light by a light emitting device is always measured, and the driving current to be supplied to the light emitting device is controlled such that the measured level can be constant (refer to Laid-open Patent Publication No. 2007-194576 and Japanese Laid-open Patent Publication No. 2003-218460, for example).

However, with the aforesaid conventional technology, the aged deterioration of a light emitting device decreases the ratio of the level of output light by the light emitting device to driving current. Therefore, controlling the output optical light level to be constant by APC causes a problem that the driving current to be supplied to a light emitting device increases.

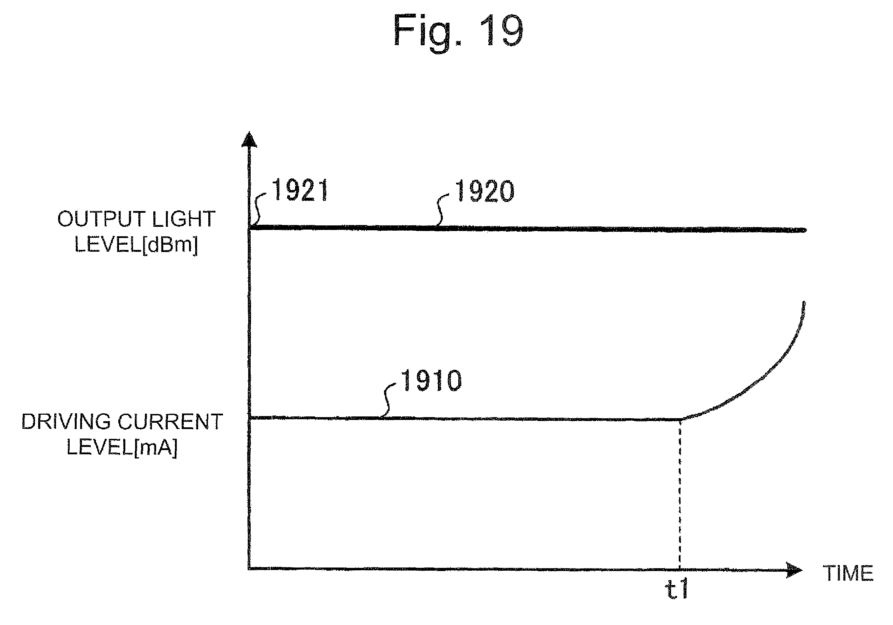

Fig. 19 is a graph showing an action of APC in a case where a light emitting device is aged, deteriorated. In Fig. 19, the horizontal axis indicates times. The vertical axis indicates levels [mA] of driving current to be supplied to a light emitting element and levels [dBm] of output light by a light emitting device. The reference numeral 1910 indicates a change in level of driving current to be supplied to a light emitting device.

The reference numeral 1920 indicates a change in output light level of a light emitting element. The reference numeral 1921 indicates the set value set by APC. APC controls the driving current level such that the output light level indicated by the reference numeral 1920 can be the set value 1921. It is assumed that, the aged deterioration of a light emitting device starts at a time t1 After the start of the aged deterioration of the light emitting device, the ratio of the output light level of a light emitting device to the driving current level decreases.

In this case, since the driving current level is controlled by the action of APC such that the output light level indicated by the reference numeral 1920 can be the set value 1921, the driving current level increases after the time t1. Therefore, a problem arises that the current consumption by the light emitting element increases. The increase in current consumption by a light emitting element increases the temperature of the light emitting element, which has a thermal influence on peripheral parts of the light emitting element. Therefore, a problem arises that the stability of the operation of the optical transmitter is deteriorated.

Against them, the light emitting device may be turned off if an abnormal increase in driving current level is detected. However, turning off the light emitting device causes a problem that the line is disconnected until the light emitting device is replaced. The abnormal increase in driving current level is also caused by the other factors than the aged deterioration of a light emitting device. Therefore, if an abnormal increase in driving current level is detected, a user cannot determine whether a light emitting device is deteriorated or any other part has a failure, and it is difficult to address the abnormality, which is another problem.

The disclosed optical transmitted and control method were made for solving the aforesaid problems, and the object is to detect the aged deterioration of a light emitting device and suppress an increase in power consumption of the optical transmitter.

SUMMARY

Accordingly, it is an object in one aspect of the embodiment to provide an optical transmitter to control power consumption on the bases of the for aged deterioration.

According to an aspect of the invention, an optical transmitter includes:

> a light emitting device being provided a driving current and for emitting light on the bases of the driving current;
> a light measure for measuring an output light power level of the light emitting device;
> a controller for controlling the driving current to the light emitting device and for changing the measured output light power level into a set output light power level of the light emitting device;
> a current measure for measuring a level of the driving current to the light emitting device;
> an abnormality detector for detecting an aged deterioration of the light emitting device on the bases of the current level of the driving current by the current measure and the measured output light power level by the light measure; and
> an adjuster for reducing the set output light power level in the controller when the abnormality detector detects the aged deterioration of the light emitting device.

The object and advantages of the invention will be realized and attained by means of the elements and combinations particularly pointed out in the claims. It is to be understood that both the foregoing general description and the following detailed description are exemplary and explanatory and are not restrictive of the invention, as claimed.

BRIEF DESCRIPTION OF THE DRAWINGS

Fig. 1 is a block diagram showing a functional configuration of the optical transmitter according to Embodiment 1.

Fig. 2 is a graph exhibiting the characteristic of the power of output light by a light emitting device to driving current.

Fig. 3 is a diagram showing the adjustment of set values by an adjuster.

Fig. 4 is a graph showing the relationship between temperatures of a light emitting device and the driving current levels.

Fig. 5 is a diagram showing an example of the table for detecting an abnormal state.

Fig. 6 is a flowchart showing an example of the operations of the optical transmitter.

Fig. 7 is a block diagram showing a functional configuration of the optical transmitter according to Embodiment 2.

Fig. 8 is a block diagram showing a mechanical configuration of the optical transmitter according to Embodiment 3.

Fig. 9 is a block diagram showing Variation Example 1 of the optical transmitter shown in Fig. 8.

Fig. 10 is a block diagram showing Variation Example 2 of the optical transmitter shown in Fig. 8.

Fig. 11 is a block diagram showing Variation Example 3 of the optical transmitter shown in Fig. 8.

Fig. 12 is a diagram showing the adjustment of a set value in the optical transmitter according to Embodiment 4.

Fig. 13 is a flowchart showing an example of the operations by the optical transmitter upon detection of the aged deterioration.

Fig. 14 is a block diagram showing a functional configuration of the optical transmitter according to Embodiment 5.

Fig. 15 is a block diagram showing a functional configuration of the optical transmitter according to Embodiment 6.

Fig. 16 is a block diagram showing Variation Example 1 of the optical transmitter shown in Fig. 15.

Fig. 17 is a block diagram showing Variation Example 2 of the optical transmitter shown in Fig. 15.

Fig. 18 is a block diagram showing Variation Example 3 of the optical transmitter shown in Fig. 15.

Fig. 19 is a graph showing an action of APC in a case where a light emitting device is aged, deteriorated.

DESCRIPTION OF EMBODIMENTS

With reference to the attached drawings, preferred embodiments of the optical transmitter and control method according to the present invention will be described in detail below,

Embodiment 1

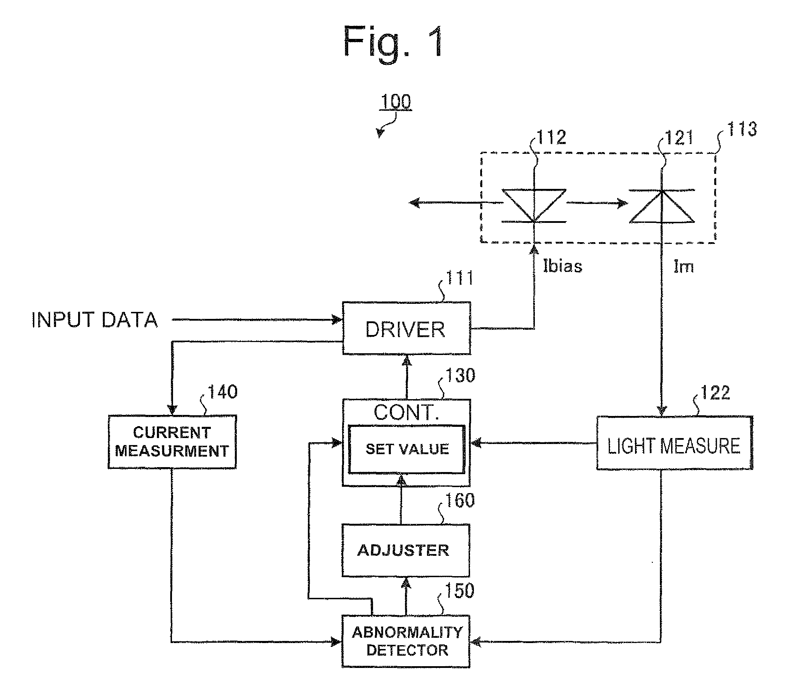

Fig. 1 is a block diagram showing a mechanical configuration of an optical transmitter according to Embodiment 1. As shown in Fig. 1, an optical transmitter 100 according to Embodiment 1 includes a drive portion 111, a light emitting device 112, a back photoreceptor 121, a light measure 122, a controller 130, a current measure 140, an abnormality detector 150 and an adjuster 160. The optical transmitter 100 is an optical transmitter that externally outputs an optical signal based on input data.

The drive portion 111 supplies driving current (Ibias) to the light emitting device 112. The drive portion 111 supplies the drive signal modulated in accordance with external input data to the light emitting device 112. The drive portion 111 changes the level of the driving current to be supplied to the light emitting device 112 under the control of the controller 130. Here, it is assumed that the level of current or light refers to the average value or center value of the power of current or light. The drive portion 111 outputs the current of the power according to the power of the driving current to be supplied to the light emitting device 112 to the current measure 140.

The light emitting device 112 outputs the light according to the driving current supplied from the drive portion 111 to the outside of the optical transmitter 100 (the arrow directing to the left). The light emitting device 112 may be an LD (Laser Diode), for example. The light emitting device 112 outputs the light of the power according to the power of light to be output to the outside to the back photoreceptor 121 (the arrow directing to the right). Here, the light emitting device 112 and the back photoreceptor 121 compose an integral LD module 113.

The back photoreceptor 121 and light measure 112 are optical measurement means for measuring the level of light output from the light emitting device 112. The back photoreceptor 121 receives the light output from the light emitting device 112 and outputs the current (Im) of the power according to the power of the received light to the light measure 112. The back photoreceptor 121 may be a PD (Photo Diode).

The light measure 112 measures the level of output light by the light emitting device 112 on the basis of the current output from the back photoreceptor 121. For example, the light measure 122 measures the average power of the current output from the back photoreceptor 121 as the level of the output light. The light measure 122 outputs the information describing the level of the measured light to the controller 130 and abnormality detector 150.

The controller 130 performs feedback control that controls the driving current to be supplied from the driving unit 111 to the light emitting device 112 such that the information output from the light measure 112 can be a set value. The set value in the controller 130 is set such that the level of the output light by the light emitting device 112 can have an ideal value at the initial state in a case where the optical transmitter 100 operates normally.

The set value is adjusted by the adjuster 160. If the information that a circuit abnormality or damage in the light emitting device 112 has been detected is output from the abnormality detector 150, the controller 130 controls the drive portion 111 such that the drive portion 111 can stop the driving current to be supplied to the light emitting device 112. Thus, the controller 130 can turn off the light emitting device 112.

The current measure 140 measures the level of the driving current to be supplied from the drive portion 111 to the light emitting device 112. More specifically, the current measure 140 measures the average power of the current output from the drive portion 111 as the level of the driving current. The current measure 140 outputs the information indicating the level of the measured driving current to the abnormality detector 150.

The abnormality detector 150 detects an abnormal state of the optical transmitter 100 (or the own apparatus) on the basis of the level of the driving current indicated by the information output from the current measure 140 and the level indicated by the information output from the light measure 122. The types of abnormal states to be detected by the abnormality detector 150 may include damage in the light emitting device 112 and an aged deterioration of the light emitting device 112.

If an aged deterioration of the light emitting device 112 is detected, the abnormality detector 150 outputs the information indicating the fact to the adjuster 160. If a circuit abnormality or damage in the light emitting device 112 is detected, the abnormality detector 150 outputs the information indicating the fact to the controller 130. The abnormality detector 150 detects at least an aged deterioration of the light emitting device 112 among abnormal states of the optical transmitter 100.

The aged deterioration of the light emitting device 112 among abnormal states is a state that the light emitting device 112 is deteriorated for long-term use, and the ratio of the level of output light to the level of driving current to be supplied decreases. The circuit abnormality is a state due to an abnormality in a circuit excluding the light emitting device 112 among the states that the optical transmitter 100 is disabled to operate normally. The damage in the light emitting device 112 is a state that the light emitting device 112 is damaged and does not emit light constant in response to the supply of driving current.

If the information describing that the aged deterioration of the light emitting device 112 is output from the abnormality detector 150, the adjuster 160 adjusts to reduce the set value in the controller 130. The amount of reduction of the set value in the controller 130 by the adjuster 160 is an amount in a range that the light emitting device 112 is not turned off and the light externally output from the light emitting device 112 can be transmitted. For example, the adjuster 160 reduces the set value in the controller 130 by the order of 1 dB.

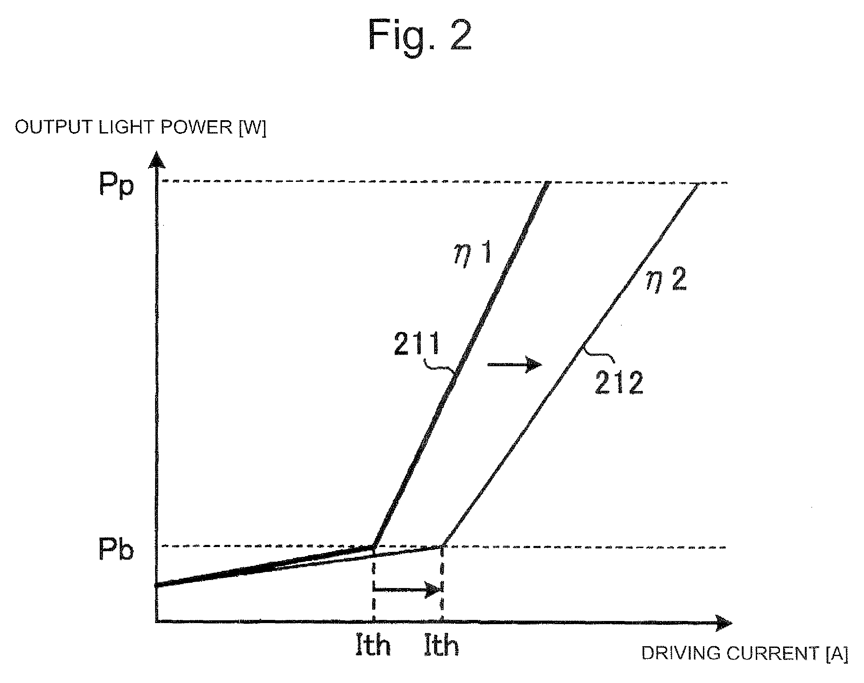

Fig. 2 is a graph showing the characteristic of the power of output light by the light emitting device to driving current. In Fig. 2, the horizontal axis indicates the amounts [A] of driving current to be supplied to the light emitting device 112. The vertical axis indicates powers [W] of the output light by the light emitting device 112. The power characteristic 211 indicates the power characteristic of the output light before the aged deterioration of the light emitting device 112. The power characteristic 212 indicates the power characteristic of the output light after the aged deterioration of the light emitting device 112.

Pp on the vertical axis indicates the peak power of the output light by the light emitting device 112. Pb indicates the bottom power of the output light by the light emitting device 112. The threshold value Ith on the horizontal axis is a value of driving current producing the power of the output light by the light emitting device 112 at the bottom power Pb. As indicated by the power characteristic 211 and power characteristic 212, the power of the output light by the light emitting device 112 increases in proportion to the driving current equal to or higher than the threshold value Ith.

When the light emitting device 112 is aged, deteriorated, the ratio of the power of the output light by the light emitting device 112 to the amount of the driving current decreases. For that reason, the threshold value Ith of the power characteristic 212 becomes higher than the threshold value Ith of the power characteristic 211. The gradient η2 [W/A] of the power characteristic 212 is smaller than the gradient η1 [W/A] of the power characteristic 211.

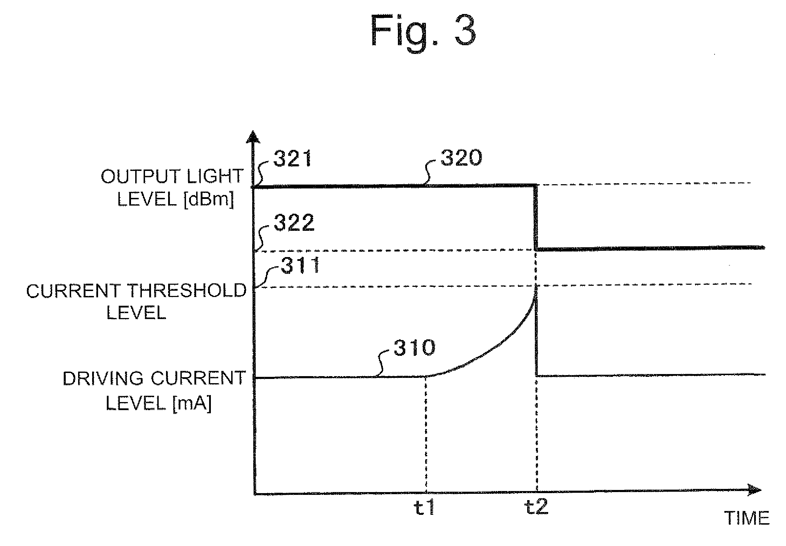

Fig. 3 is a diagram showing the adjustment of the set values by the adjuster. In Fig. 3, the horizontal axis indicates times. The vertical axis indicates the level of driving current to be supplied to the light emitting device 112 (which will be simply called "driving current level" hereinafter) [mA] and the level of the output light by the light emitting device 112 (which will be simply called "output light level" hereinafter) [dBm]. The output light level herein is a level indicated by the information output from the light measure 112 to the controller 130.

The reference numeral 310 indicates changes in level of driving current to be supplied to the light emitting device 112. The reference numeral 320 indicates a change in output light level of he light emitting device 112. The reference numeral 321 indicates the set value which is set at the initial state in the controller 130. At the initial state, the controller 130 controls the driving current level such that the output light level can be the set value 321.

It is assumed here that the aged deterioration of the light emitting device 112 starts at a time t1. After the aged deterioration of the light emitting device 112 starts, the ratio of the output light level of the light emitting device 112 to the driving current level decreases (refer to Fig. 2). On the other hand, the driving current level after the time t1 increases since the controller 130 controls the driving current level such that the output light level can be the set value 321.

It is assumed that the driving current level exceeds a predetermined current threshold value 311 at a time t2 after the time t1. At that time, the aged deterioration is detected by the abnormality detector 150. Then, the adjuster 160 adjusts the set value in the controller 130 to be the set value 322, which is lower than the set value 321. Thus, because the controller 130 controls the driving current level such that the output light level can be the set value 322, the driving current level after the time t2 decreases.

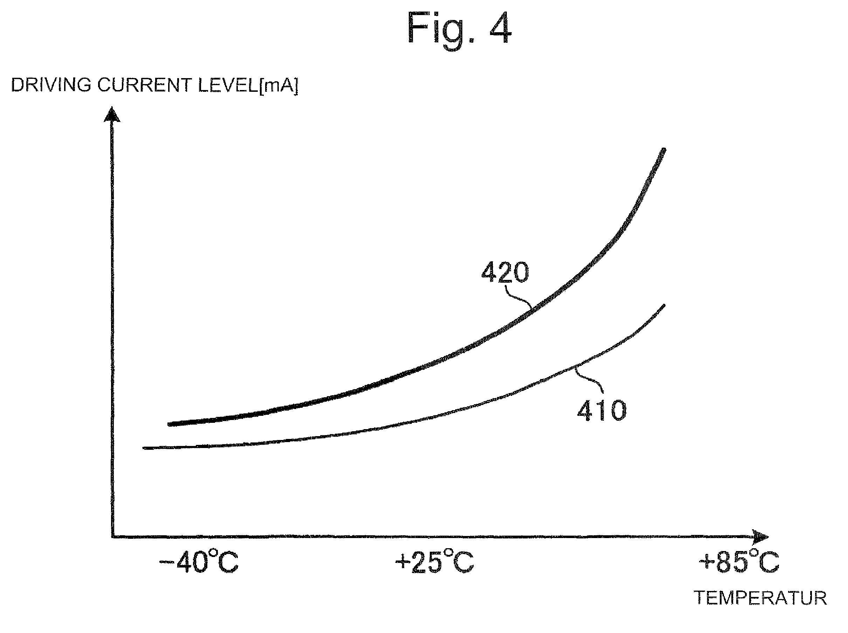

Fig. 4 is a graph showing the relationship between temperatures of the light emitting device and the driving current levels. In Fig. 4, the horizontal axis indicates the temperatures of the light emitting device 112. The vertical axis indicates the levels [mA] of the driving current to be supplied to the light emitting device 112 when the controller 130 controls the power of the output light by the light emitting device 112 to a normal level (ideal level). The characteristic 410 indicates the characteristic of the driving current level to the temperature of the light emitting device 112 before the aged deterioration of the light emitting device 112.

The ratio of the output light level of the light emitting device 112 to the driving current level decreases as the temperature of the light emitting device 112 increases, irrespective of the aged deterioration of the light emitting device 112. Thus, as indicated by the characteristic 410, the driving current level when the controller 130 controls the power of the output light by the light emitting device 112 to a normal level increases as the temperature of the light emitting device 112 increases.

Therefore, irrespective of the aged deterioration of the light emitting device 112, the driving current level varies in accordance with the temperature of the light emitting device 112. For that reason, the current threshold value (current threshold value 311 in Fig. 3) for detecting the aged deterioration of the light emitting device 112 on the basis of the driving current level may be preferably set to different values for the temperatures of the light emitting device 112. For example, a temperature sensor that measures the temperature of the light emitting device 112 may be provided in the light emitting device 112, and the information on the temperature measured by the temperature sensor is output to the abnormality detector 150.

It is assumed here that the temperature indicated by the information output from the temperature sensor is T. The level L(T) of the driving current to be supplied to the light emitting device 112 is assumed when the power of the output light by the light emitting device 112 is controlled to a normal level (ideal level) at a temperature T. The abnormality detector 150 calculates L(T) on the basis of the temperature T indicated by the information output from the temperature sensor and the characteristic 410. The abnormality detector 150 calculates a current threshold value TH by:

$$TH = L(T) \times 1.5 \text{ [EQ1]}$$

In this case, the current threshold value TH is the value (or characteristic 420) resulting from the multiplication of the driving current level of the characteristic 410 by 1.5 at each temperature. The abnormality detector 150 dynamically changes the current threshold value TH as in the characteristic 420 in accordance with the temperature of the light emitting device 112, which is measured by the temperature sensor. This can avoid the improper detection of the aged deterioration due to a change in temperature of the light emitting device 112 even though the light emitting device 112 is not aged, deteriorated.

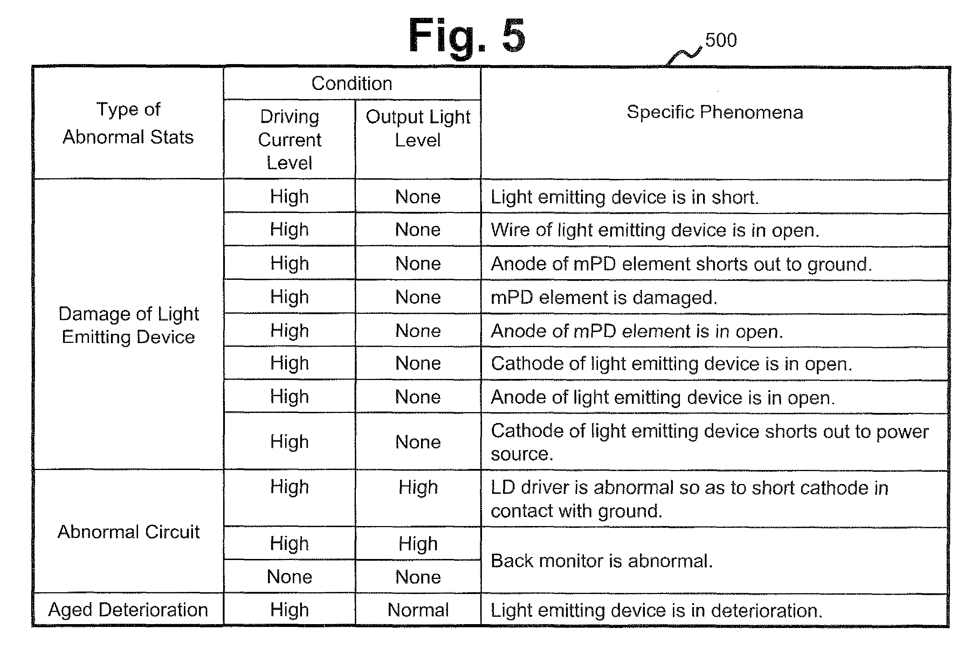

Fig. 5 is a diagram showing an example of the table for detecting an abnormal state. The abnormality detector may have a table 500, for example, in order to detect an abnormal state of the optical transmitter 100 for each type. The table 500 has correspondence between an abnormal state of the optical transmitter 100 and a combination of a condition of the driving current level and a condition of the output light level.

Here, it is assumed that, if the driving current level indicated by the information output from the current measure 140 exceeds the current threshold value (current threshold value 311 in Fig. 3), the driving current level is "High". It is further assumed that, if the driving current level indicated by the information output from the current measure 140 is approximately zero (which is a case where no driving current is supplied to the light emitting device 112), the driving current level is "None".

It is further assumed that, if the output light level indicated by the information output from the light measure 122 is approximately zero (which is a case where the light emitting device 112 is off), the output light level is "None". It is further assumed that, if the output light level indicated by the information output from the light measure 122 is a normal level, the output light level is "Normal". The normal level refers to the output light level when the optical transmitter 100 operates normally at the initial state.

It is further assumed that, if the output light level indicated by the information output from the light measure 122 exceeds a light threshold value, the output light level is "High". The light threshold value is a value higher than the output light level when the optical transmitter 100 operates normally at the initial state. For example, if the driving current level is "High" and the output light level is "None", the abnormality detector 150 detects damage in the light emitting device 112 as an abnormal state of the optical transmitter 100.

If the driving current level is "High" and the output light level is "High", the abnormality detector 150 detects a circuit abnormality as an abnormal state of the optical transmitter 100. If the driving current level is "None" and the output light level is "None", the abnormality detector 150 detects a circuit abnormality as an abnormal state of the optical transmitter 100.

If the driving current level is "High" and the output light level is "Normal", the abnormality detector 150 detects the aged deterioration of the light emitting device 112 as an abnormal state of the optical transmitter 100. This is because, if the aged deterioration of the light emitting device 112 occurs, the driving current level increases as described above, and the output light level is controlled to be constant by the controller 130.

Here, the table 500 has correspondence between combinations of the condition of the driving current level and the condition of the output light level and specific phenomena of abnormal states. The table 500 includes information on a more specific phenomenon of the optical transmitter 100 than the type of an abnormal state for each combination of the condition of a driving current level and the condition of the output light level.

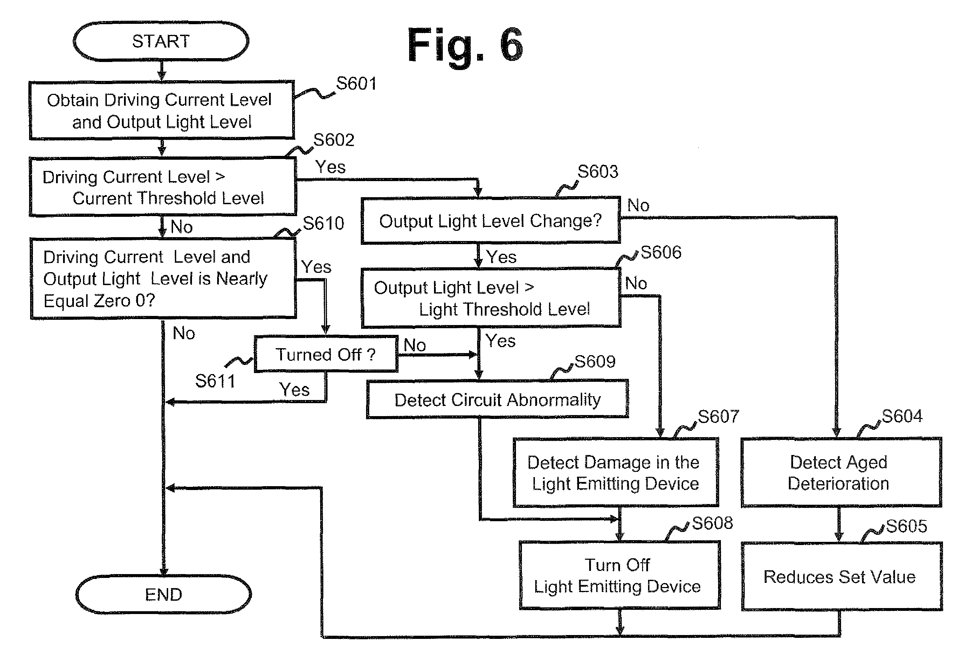

Fig. 6 is a flowchart showing an example of the operations of the optical transmitter. As shown in Fig. 6, the abnormality detector 150 first obtains the driving current level indicated by the information output from the current measure 140 and the output light level indicated by the information output from the light measure 122 (step S601). Next, whether the driving current level obtained by step S601 exceeds the current threshold value (current threshold value 311 in Fig. 3) or not is determined (step S602).

If the driving current level exceeds the current threshold value in step S602 (step S602: Yes), whether the output light level obtained in step S601 changes about the normal level or not is determined (step S603). If the output light level does not change about the normal level (step S603: No), the aged deterioration of the light emitting device 112 is detected as an abnormal state of the optical transmitter 100 (step S604).

Next, the adjuster 160 reduces the set value in the controller 130 (step S605), and the processing ends. If the output light level changes about the normal level in step S603 (step S603: Yes), whether the output light level obtained by step S601 exceeds the light threshold value or not is determined (step S606).

If the output light level obtained by step S601 exceeds the light threshold value in step S606 (step S606: No), damage in the light emitting device 112 is detected as an abnormal state of the optical transmitter 100 (step S607). Next, the controller 130 turns off the light emitting device 112 (step S608), and the processing ends.

If the output light level exceeds the light threshold value in step S606 (step S606: Yes), a circuit abnormality is detected as an abnormal state of the optical transmitter 100 (step S609). The processing moves to step S608 and continues. If the driving current level does not exceed the current threshold value in step S602 (step S602: No), whether both of the driving current level and output light level are equal to approximately zero or not is determined (step S610).

If both of the driving current level and output light level are not equal to approximately zero in step S610 (step S610: No), the processing ends. If both of the driving current level and output light level are equal to approximately zero (step S610: Yes), whether the light emitting device 112 is turned off by step S608 or not is determined (step S611).

If the light emitting device 112 is turned off by step S608 (step S611: Yes), the processing ends. If the light emitting device 112 is not turned off by step S608 (step S611: No), the processing moves to step S609 and continues. By repeating the processing above, an abnormal state of the optical transmitter 100 can be detected in real time.

In this way, in the optical transmitter 100 according to Embodiment 1, by measuring and using the level of output light by the light emitting device 112 and the level of driving current to be supplied to the light emitting device 112, the type of abnormal state of the optical transmitter 100 can be determined. Thus, the aged deterioration of the light emitting device 112 can be detected distinctly from other abnormal states.

If the aged deterioration of the light emitting device 112 is detected, the increase in driving current can be suppressed by reducing the set value for the feedback control over the output light level of the light emitting device 112. Therefore, if the aged deterioration of the light emitting device 112 occurs, the increase in power consumption by the optical transmitter 100 can be suppressed while the operations by the optical transmitter 100 are being continued.

By suppressing the increase in driving current, the thermal influence on the peripheral parts of the light emitting device 112 can be avoided. Therefore, the optical transmitter 100 can be operated in a stable manner even though the aged deterioration of the light emitting device 112 occurs. Furthermore, setting different values for temperatures of the light emitting device 112 as the current threshold value for detecting the aged deterioration of the light emitting device 112 can avoid the improper detection of the aged deterioration due to the change in temperature of the light emitting device 112 even though the light emitting device 112 is not aged, deteriorated.

Embodiment 2

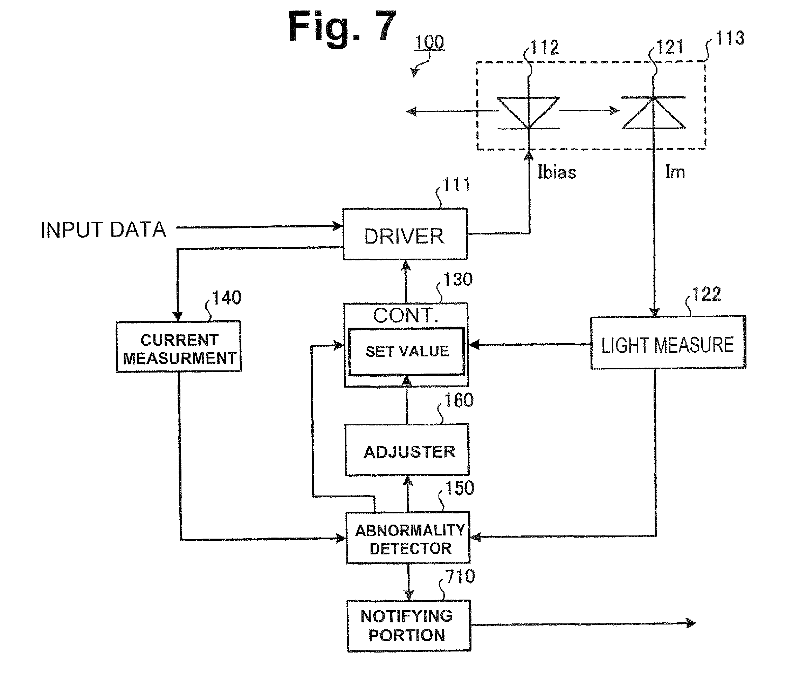

Fig. 7 is a block diagram showing a functional configuration of the optical transmitter according to Embodiment 2. In Fig. 7, the same reference numerals are given to the same components as the components shown in Fig. 1, and the description thereon will be omitted herein. As shown in Fig. 7, the optical transmitter 100 according to Embodiment 2 further includes a notifying portion 710 in addition to the components shown in Fig. 1. If an abnormal state of the optical transmitter 100 is detected, the abnormal detecting portion 150 outputs the information indicating the detected type of abnormal state to the notifying portion 710.

The notifying portion 710 externally notifies the type of abnormal state indicated by the information output by the abnormality detector 150. For example, the notifying portion 710 may be a display portion that visually displays information to a user. In this case, the notifying portion 710 displays the type of abnormal state indicated by the information output from the abnormality detector 150. Thus, a user can learn the type of abnormal state of the optical transmitter 100 and take measure according to the type of abnormal state.

The information to be notified by the notifying portion 710 is at least information that the aged deterioration of the light emitting device 112 has been detected. Thus, a user can roughly estimate the time for replacement of the light emitting device 112. Therefore, a user can smoothly perform the maintenance based on the aged deterioration of the light emitting device 112. The information to be notified by the notifying portion 710 may be only the type of the abnormal state of the optical transmitter 100 or a specific phenomenon of an abnormal state (refer to Fig. 5).

In this way, the optical transmitter 100 according to Embodiment 2 can provide the advantages of the optical transmitter 100 according to Embodiment 1 and facilitate the maintenance of the optical transmitter 100 by a user by notifying the user of an abnormal state of the optical transmitter 100, which is detected by the abnormality detector 150.

Embodiment 3

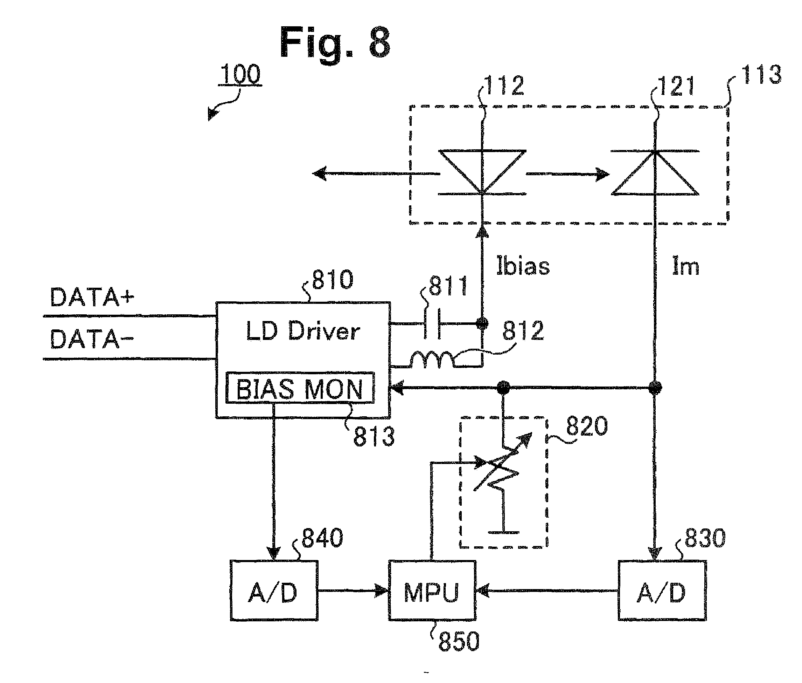

Fig. 8 is a block diagram showing a mechanical configuration of the optical transmitter according to Embodiment 3. In Fig. 8, the same reference numerals are given to the same components as the components shown in Fig. 1, and the description thereon will be omitted herein. The optical transmitter 100 according to Embodiment 3 is a specific configuration example of the optical transmitter 100 according to Embodiment 3. As shown in Fig. 8, the optical transmitter 100 according to Embodiment 3 includes the light emitting device 112, the back photoreceptor 121, an LD driver 810, a digital variable resistor 820, an A/D converter 830, an A/D converter 840 and an MPU 850.

The back photoreceptor 121 outputs the current of the power according to the power of the received light to the LD driver 810 and A/D converter 830. The LD driver 810 supplies modulated current as driving current to the light emitting device 112 through a capacitor 811. The mutually inverted DATA+ and DATA- are externally input to the LD driver 810.

The LD driver 810 modulates the current for modulation in accordance with the DATA+ and DATA- and supplies it as the driving current to the light emitting device 112. The LD driver 810 outputs the bias current through an inductor 812. The bias current output from the LD driver 810 is added to the driving current to be supplied to the light emitting device 112. Therefore, the level of the driving current to be supplied to the light emitting device 112 depends on the bias current output by the LD driver 810.

The LD driver 810 further controls the bias current to be supplied to the light emitting device 112 by handling the level of the current output from the back photoreceptor 121 as the set value (the set values 321 and 322 in Fig. 3). A bias monitor 813 (BIAS MON) included in the LD driver 810 measures the power of the bias current output by the LD driver 810 and outputs the current of the power according to the measured power to the A/D converter 840.

The A/D converter 830 converts the level of the current output from the back photoreceptor 121 to a digital signal. The A/D converter 830 outputs the converted digital signal to the MPU 850. The A/D converter 840 converts the level of the current output from the bias monitor 813 of the LD driver 810 to a digital signal. The A/D converter 840 outputs the converted digital signal to the MPU 850.

The digital variable resistor 820 has one end connecting to the path of the current output from the back photoreceptor 121 to the LD driver 810 and the other end grounded. The resistance value of the digital variable resistor 820 is changed under the control of the MPU 850. The LD driver 810 operates such that the current level output from the back photoreceptor 121 decreases as the resistance value of the digital variable resistor 820 increases. The LD driver 810 operates such that the current level output from the back photoreceptor 121 increases as the resistance value of the digital variable resistor 820 decreases.

The MPU 850 (Micro Processing Unit) detects an abnormal state of the optical transmitter 100 on the basis of the driving current level indicated by the digital signal output from the A/D converter 840 and the output light level indicated by the digital signal output from the A/D converter 830. The operation that detects an abnormal state of the optical transmitter 100 by the MPU 850 is the same as the operation by the abnormality detector 150 according to Embodiment 1. The MPU 850 increases the resistance value of the digital variable resistor 820 if the aged deterioration of the light emitting device 112 is detected as an abnormal state.

Thus, the LD driver 810 operates such that the current level output from the back photoreceptor 121 can decrease. This can reduce the set value for the control over the bias current to be supplied to the light emitting device 112. This is equivalent to the reduction of the set value in the controller 130 in Fig. 1. This reduces the output light level of the light emitting device 112.

The MPU 850 turns off the light emitting device 112 if the MPU 850 detects a circuit abnormality or damage in the light emitting device 112 as an abnormal state. For example, the MPU 850 turns off the light emitting device 112 by outputting the control signal to the LD driver 810 (not shown) to terminate the supply of the driving current from the LD driver 810 to the light emitting device 112.

The LD driver 810 corresponds to the driving portion 111 and the controller 130 shown in Fig. 1. The bias monitor 813 and A/D converter 840 correspond to the current measure 140 shown in Fig. 1. The A/D converter 830 corresponds to the light measure 122 shown in Fig. 1. The MPU 850 corresponds to the abnormality detector 150 shown in Fig. 1. The digital variable resistor 820 corresponds to the adjuster 160 shown in Fig. 1.

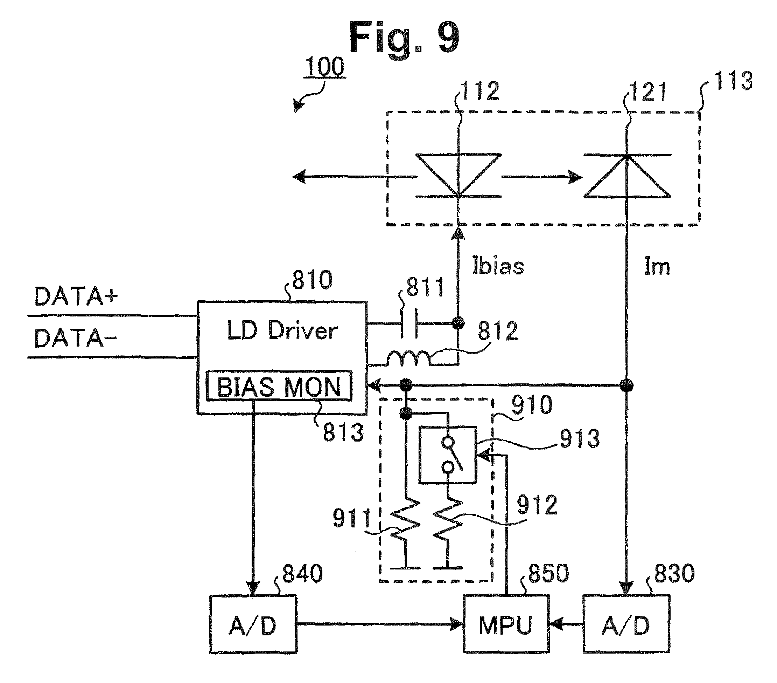

Fig. 9 is a block diagram showing Variation Example 1 of the optical transmitter shown in Fig. 8. In Fig. 9, the same reference numerals are given to the same components as the components shown in Fig. 8, and the description thereon will be omitted herein. As shown in Fig. 9, the optical transmitter 100 according to Embodiment 3 may include an analog variable resistance circuit 910 instead of the digital variable resistor 820 shown in Fig. 8.

The analog variable resistance circuit 910 includes a resistor 911, a resistor 912 and an analog switch 913. The resistor 911 has one end connecting to the path of the current to be output from the back photoreceptor 121 to the LD driver 810 and the other end grounded. The resistor 912 has one end connecting to the analog switch 913 and the other end grounded.

The analog switch 913 has one end connecting to between the path of the current to be output from the back photoreceptor 121 to the LD driver 810 and the resistor 911 and the other end connecting to the resistor 912. The analog switch 913 is turned on/off to switch the connection/disconnection of the both ends. The analog switch 913 is turned on/off under the control of the MPU 850.

If the analog switch 913 is turned from ON to OFF, the state that the resistor 911 and the resistor 912 are connected in parallel to the state that the resistor 911 is serially connected thereto, which increases the resistance value of the analog variable resistance circuit 910. Thus, the LD driver 810 operates such that the current level output from the back photoreceptor 121 can decrease. If the analog switch 913 is turned from OFF to ON, the resistor 911 and the resistor 912 are connected in parallel, which reduces the resistance value of the analog variable resistance circuit 910. Thus, the LD driver 810 operates such that the current level output from the back photoreceptor 121 can increase.

The MPU 850 initially keeps the analog switch 913 ON. The MPU 850 turns off the analog switch 913 if the aged deterioration of the light emitting device 112 is detected. Thus, the LD driver 810 operates such that the current level can decrease. This is equivalent to the reduction of the set value for the controller 130 in Fig. 1. Thus, the level of the driving current to be supplied to the light emitting device 112 decreases, and the output light level decreases.

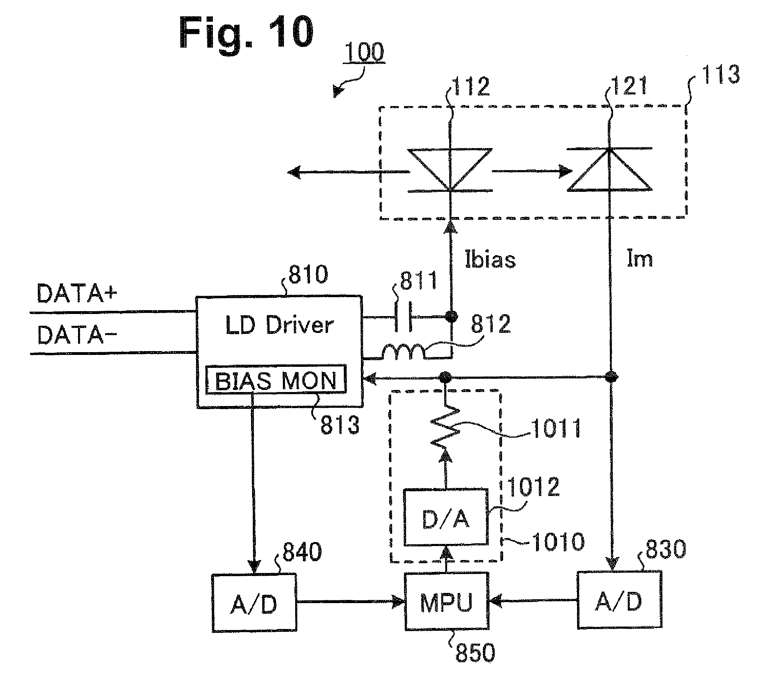

Fig. 10 is a block diagram showing Variation Example 2 of the optical transmitter shown in Fig. 8. In Fig. 10, the same reference numerals are given to the same components as the components shown in Fig. 8, and the description thereon will be omitted herein. As shown in Fig. 10, the optical transmitter 100 according to Embodiment 3 may include a D/A converting portion 1010 instead of the digital variable resistor 820 shown in Fig. 8.

The D/A converting portion 1010 includes a resistor 1011 and a D/A converter 1012. The resistor 1011 has one end connecting to the path of the current to be output from the back photoreceptor 121 to the LD driver 810 and the other end connecting to the D/A converter 1012. The D/A converter 1012 has the digital side connecting to the MPU 850 and the analog side connecting to the resistor 1011. The set voltage in the D/A converter 1012 is set by the MPU 850.

The LD driver 810 operates such that the current level output from the back photoreceptor 121 can decrease as the set voltage of the D/A converter 1012, which is set by the MPU 850, increases. The LD driver 810 operates such that the current level output from the back photoreceptor 121 increases as the set voltage in the D/A converter 1012, which is set by the MPU 850, decreases.

The MPU 850 initially keeps small set voltage of the D/A converter 1012. The MPU 850 increases the set voltage of the D/A converter 1012 if the aged deterioration of the light emitting device 112 is detected. Thus, the LD driver 810 operates such that the current level can decrease. This is equivalent to the reduction of the set value in the controller 130 in Fig. 1.

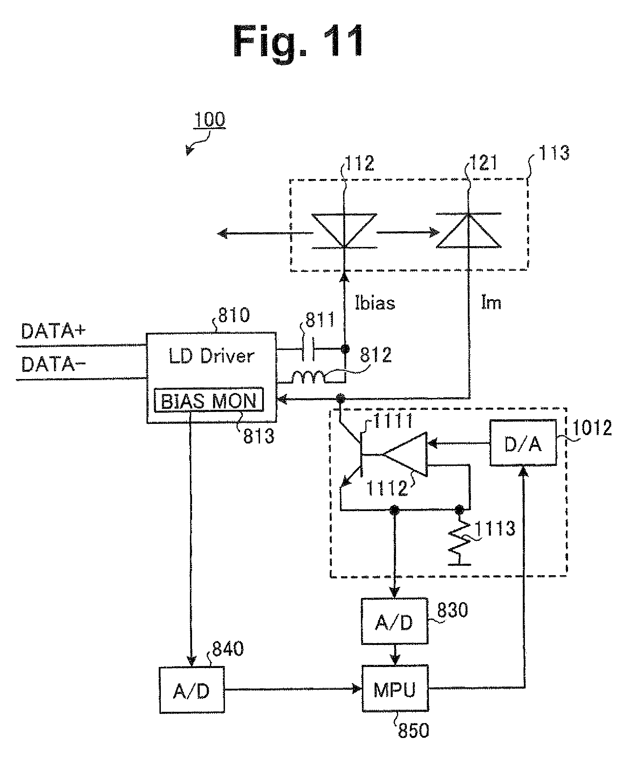

Fig. 11 is a block diagram showing Variation Example 3 of the optical transmitter shown in Fig. 8. In Fig. 11, the same reference numerals are given to the same components as the components shown in Fig. 10, and the description thereon will be omitted herein. As shown in Fig. 11, the optical transmitter 100 according to Embodiment 3 may include a transistor 1111 and an operational amplifier 1112 instead of the resistor 1011 shown in Fig. 10.

The collector of the transistor 111 connects to the path of the current to be output from the back photoreceptor 121 to the LD driver 810. The emitter of the transistor 1111 connects to a common-mode input terminal of the operational amplifier 1112 and the A/D converter 830. The base of the transistor 1111 connects to the output terminal of the operational amplifier 1112. The resistor 1113 connects to the common-mode input terminal of the operational amplifier 1112.

The A/D converter 830 does not directly connect to the back photoreceptor 121 here. The A/D converter 830 converts the peak power of the current output from the emitter of the transistor 1111 to a digital signal. The A/D converter 830 outputs the converted digital signal to the MPU 850. The D/A converter 1012 outputs the current of the power according to the set voltage, which is set by the MPU 850, to the opposite-mode input terminal of the operational amplifier 1112.

The LD driver 810 operates such that the current level output from the back photoreceptor 121 can decrease as the set voltage in the D/A converter 1012, which is set by the MPU 850, decreases. The LD driver 810 operates such that the current level output from the back photoreceptor 121 can increase as the set voltage in the D/A converter 1012, which is set by the MPU 850, increases.

The MPU 850 initially sets large set voltage in the D/A converter 1012. The MPU 850 sets small set voltage in the D/A converter if the aged deterioration of the light emitting device 112 is detected. Thus, the LD driver 810 operates such that the current level output from the back photoreceptor 121 can decrease. This is equivalent to the reduction of the set value in the controller 130 in Fig. 1.

In this way, the optical transmitter 100 according to Embodiment 3 allows detection of the aged deterioration of the light emitting device 112 distinctly from other abnormal states, like the optical transmitter 100 according to Embodiment 1. If the aged deterioration of the light emitting device 112 occurs, the increase in power consumption by the optical transmitter 100 can be suppressed while the operations by the optical transmitter 100 are kept.

Embodiment 4

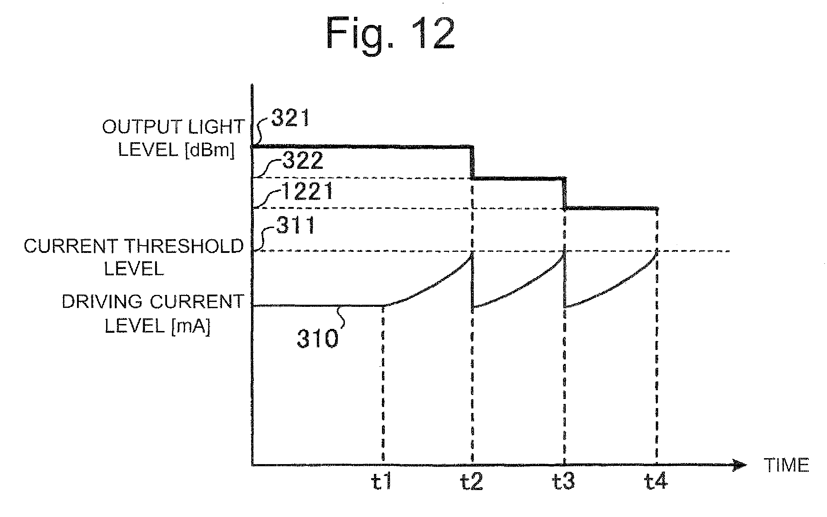

Fig. 12 is a diagram showing the adjustment of a set value in the optical transmitter according to Embodiment 4. In Fig. 12, the same reference numerals are given to the same parts as the parts shown in Fig. 3, and the description thereon will be omitted herein. After the level of the driving current to be supplied to the light emitting device 112 is reduced at a time t2, the driving current level is increased again if the aged deterioration of the light emitting device 112 advances. It is assumed that the driving current level exceeds the current threshold value 311 again at a time t3 after the time t2.

In this case, the aged deterioration is detected again by the abnormal detecting portion 150. Then, the adjuster 160 adjusts the set value in the controller 130 to be a set value 1221, which is lower than the set value 322. Therefore, the driving current level decreases at the time t3. After that, if the aged deterioration of the light emitting device 112 advances, the driving current level increases again. It is assumed that the driving current level exceeds the current threshold value 311 again at a time t4 after the time t3.

In this case, the aged deterioration is detected again by the abnormal detecting portion 150. Then, the adjuster 160 adjusts the set value in the controller 130 to be a lower set value (not shown) than the set value 1221. Therefore, the driving current level decreases at the time t4. In this way, in the optical transmitter 100 according to the present invention, the driving current level often exceeds the current threshold value 311.

This is because the power of the output light by the light emitting device 112 to the magnitude of the driving current decreases as the aged deterioration of the light emitting device 112 advances. The adjuster 160 reduces the set value every time the driving current level exceeds the current threshold value 311. It is assumed that the configuration of the optical transmitter 10 according to Embodiment 4 is similar to the configuration shown in Fig. 10 or 11. The MPU 850 detects the aged deterioration of the light emitting device 112 and counts the number of times of the reduction of the set value.

If the aged deterioration of the light emitting device 112 is detected, the MPU 850 calculates the set voltage Vs to be set in the D/A converter 1012 by:

$$Vs = V0 \times a^n \quad [EQ2]$$

In EQ2, V0 is initially set voltage in the D/A converter 1012, which is set at the initial state of the optical transmitter 100. "a" is a reduction correction coefficient for determining the amount of reduction of the set value. "n" is the number of times when the driving current level exceeds the current threshold value 311, which are counted by the MPU 850 (including the number of times of the calculation of the set voltage Vs). In this case, the set value can be smoothly reduced as the reduction correction coefficient a to be set decreases.

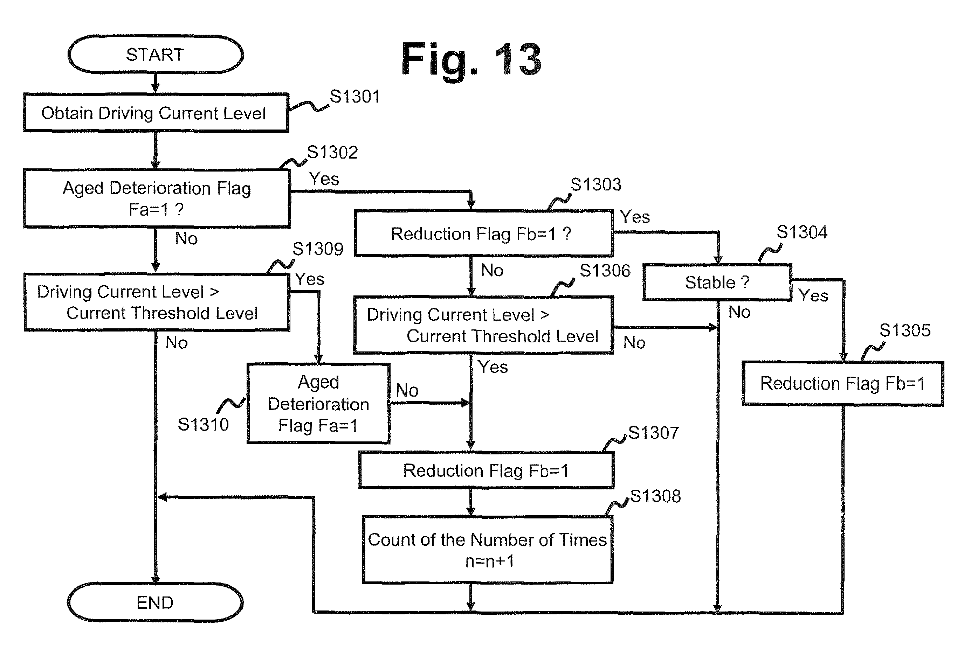

Fig. 13 is a flowchart showing an example of the operations by the optical transmitter upon detection of the aged deterioration. If the aged deterioration of the light emitting device 112 is detected by step S604 shown in Fig. 6, the optical transmitter 100 according to Embodiment 4 performs following operations. As shown in Fig. 13, the MPU 850 first obtains the driving current level (step S1301).

Next, whether an aged deterioration flag Fa is set (Fa=1) or not is determined (step S1302). The aged deterioration flag Fa is a flag indicating whether the aged deterioration of the light emitting device 112 has been detected or not. The aged deterioration flag Fa=0 indicates that the aged deterioration of the light emitting device 112 has not been detected. The aged deterioration flag Fa=1 indicates that the aged deterioration of the light emitting device 112 has been detected.

If the aged deterioration flag Fa is set (Fa=1) in step S1302 (step S1302: Yes), whether a reduction flag Fb is set (Fb=1) or not is determined (step S1303), The reduction flag Fb is a flag for determining whether the output light level of the light emitting device 112 is stable or not. The reduction flag Fb=0 indicates that the output light level of the light emitting device 112 is stable.

The reduction flag Fb=1 indicates that it is immediately after the set value for feedback control over the output light level of the light emitting device 112 has been reduced and the output light level of the light emitting device 112 has not been stable yet. If the reduction flag Fb is set (Fb=1) in step S1303 (step S1303: Yes), whether the output light level of the light emitting device 112 has been stable or not (step S1304).

If the output light level has not been stable in step S1304 (step S1304: No), the processing ends. If the output light level has been stable (step S1304: Yes), the reduction flag Fb is cleared (Fb=0) (step S1305), and the processing ends, If the reduction flag Fb is not set (Fb=0) (step S1303: No), whether the driving current level obtained by step S1301 exceeds the current threshold value or not is determined (step S1306).

If the driving current level does not exceed the current threshold value in step S1306 (step S1306: No), the processing ends. If the driving current level exceeds the current threshold value (step S1306: Yes), the reduction flag Fb is set (Fb=1) (step S1307). Next, the count n of the number of times of the reduction of the set value is incremented by one (n=n+1) (step S1308), and the processing ends.

If the aged deterioration flag Fa is not set (Fa=0) in step S1302 (step S1302: No), whether the driving current level obtained by step S1301 exceeds the current threshold value or not is determined (step S1309). If the driving current level exceeds the current threshold value (step S1309: Yes), the aged deterioration flag Fa is set (Fa=1) (step S1310). Then, the processing moves to step S1307 to continue.

If the driving current level does not exceed the current threshold value in step S1309 (step S1309: No), the processing ends. The steps above allow counting the number of times n when the driving current level exceeds the current threshold value 311. On the basis of the number of times n counted by the step above and [EQ2], the set value for adjusting in step S605 in Fig. 6 can be calculated.

In this way, the optical transmitter 100 according to Embodiment 4 can provide the advantages of the optical transmitter 100 according to Embodiment 1 and can reduce the set value for feedback control over the output light level of the light emitting device 112 in a stepwise manner in accordance with the aged deterioration of the light emitting device 112. Thus, the reduction of the output level of the light emitting device 112 can be minimized, and the increase in driving current can be suppressed.

Embodiment 5

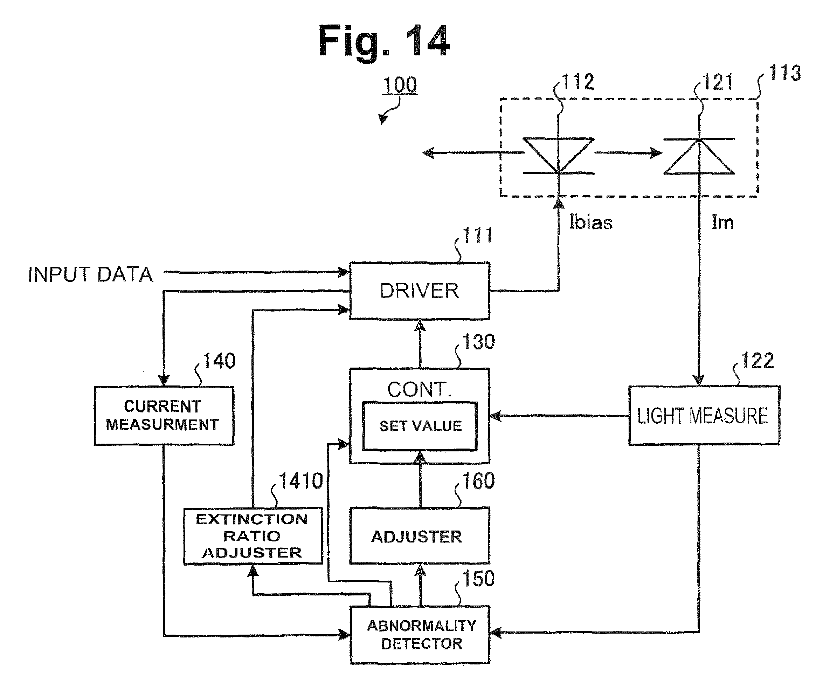

Fig. 14 is a block diagram showing a functional configuration of the optical transmitter according to Embodiment 5. In Fig. 14, the same reference numerals are given to the same components as the components shown in Fig. 1, and the description thereon will be omitted herein. As shown in Fig. 14, the optical transmitter 100 according to Embodiment 5 includes an extinction ratio adjuster 1410 in addition to the components shown in Fig. 1. If the aged deterioration of the light emitting device 112 is detected, the abnormality detector 150 outputs the information on the fact to the extinction ratio adjuster 1410.

The extinction ratio adjuster 1410 maintains the extinction ratio of the output light by the light emitting device 112 constant if the set value of the controller 130 is reduced by the adjuster 160. More specifically, if the information on the fact that the aged deterioration of the light emitting device 112 has been detected is output from the abnormality detector 150, the extinction ratio adjuster 1410 adjusts the amplitude of the driving current output by the driving portion 111 can be constant.

In this way, the optical transmitter 100 according to Embodiment 5 can provide the advantages of the optical transmitter 100 according to Embodiment 1 and can keep the extinction ratio of the output light by the light emitting device 112 constant even though the set value of the controller 130 is reduced by the adjuster 160. Therefore, even though the light emitting device 112 is aged, deteriorated, the deterioration in the transmission characteristic can be suppressed, and the operations are allowed.

Embodiment 6

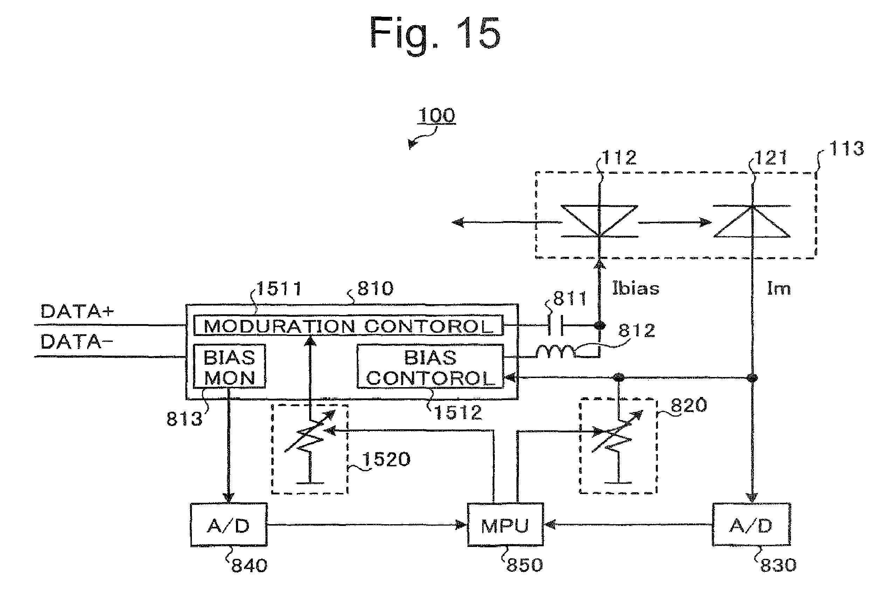

Fig. 15 is a block diagram showing a functional configuration of the optical transmitter according to Embodiment 6. The same reference numerals are given to the same components as the components shown in Fig. 8, and the description thereon will be omitted herein. The optical transmitter 100 according to Embodiment 6 is a specific configuration example of the optical transmitter 100 shown in Fig. 14. As shown in Fig. 15, the optical transmitter 100 according to Embodiment 6 includes a digital variable resistor 1520 in addition to the components shown in Fig. 8. The MPU 850 and digital variable resistor 1520 correspond to the extinction ratio adjuster 1410 shown in Fig. 14.

The LD driver 810 includes the bias monitor 813, a modulation control portion 1511 (MODULATION CONTROL), and a bias control portion 1512 (BIAS CONTROL). The modulation control portion 1511 modulates the current for modulation in accordance with the input DATA+ and DATA-. The modulation control portion 1511 supplies the modulated current as the driving current to the light emitting device 112.

The modulation control portion 1511 changes the modulation strength in accordance with the magnitude of the resistance value of the digital variable resistor 1520. If the modulation strength changes, the amplitude of the driving current to be output from the modulation control portion 1511 changes. Thus, the extinction ratio of the output light by the light emitting device 112 changes. More specifically, as the resistance of the digital variable resistor 1520 increases, the modulation strength in the modulation control portion 1511 decreases, and the extinction ratio of the output light by the light emitting device 112 decreases.

The bias control portion 1512 outputs the bias current through the inductor 812. The bias control portion 1512 controls the bias current to be supplied to the light emitting device 112 by handling the level of the current output from the back photoreceptor 121 as the set value. The digital variable resistor 1520 has one end connecting to the modulation control portion 1511 and the other end grounded. The resistance value of the digital variable resistor 1520 is changed under the control of the MPU 850.

If the aged deterioration of the light emitting device 112 is detected as an abnormal state, the MPU 850 reduces the level of the driving current by increasing the resistance value of the digital variable resistor 820 (increasing the extinction ratio) and decreases the amplitude of the driving current by increasing the resistance value of the digital variable resistor 1520. More specifically, the MPU 850 controls to maintain the ratio of the resistance values of the digital variable resistor 820 and digital variable resistor 1520. Thus, the extinction ratio can be kept constant even by decreasing the output light level of the light emitting device 112.

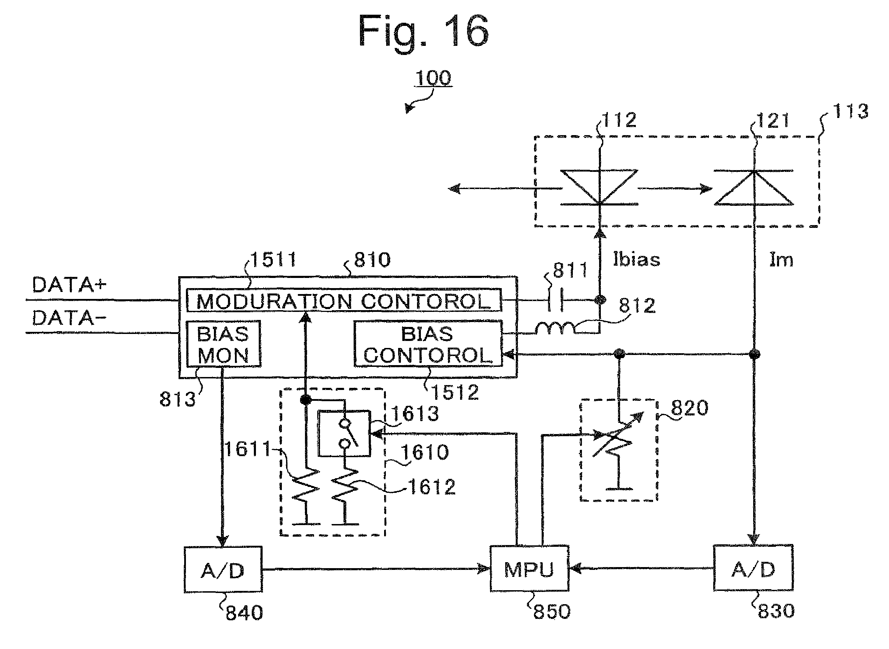

Fig. 16 is a block diagram showing Variation Example 1 of the optical transmitter shown in Fig. 15. The reference numerals are given to the same components as the components shown in Fig. 15, and the description thereon will be omitted herein. As shown in Fig. 16, the optical transmitter 100 according to Embodiment 6 may include an analog variable resistance circuit 1610 instead of the digital variable resistor 1520 shown in Fig. 15. The analog variable resistance circuit 1610 incudes a resistor 1611, a resistor 1612 and an analog switch 1613.

The resistor 1611 has one end connecting to the modulation control portion 1511 and the other end grounded. The resistor 1612 has one end connecting to the analog switch 1613 and the other end grounded. The analog switch 1613 has one end connecting to between the modulation control portion 1511 and the resistor 1611 and the other connecting to the resistor 1612. The analog switch 1613 is turned on/off to switch the connection/disconnection of both ends. The analog switch 1613 is turned on/off under the control of the MPU 850.

If the analog switch 1613 is turned from ON to OFF, the state that the resistor 1611 and the resistor 1612 are connected in parallel is switched to the state that the resistor 1611 is connected thereto in series, and the resistance value of the analog variable resistance circuit 1610 increases. Thus, the amplitude of the driving current to be output from the modulation control portion 1511 decreases. If the analog switch 1613 is turned from OFF to ON, the resistor 1611 and the resistor 1612 are connected in parallel, and the resistance value of the analog variable resistance circuit 1610 decreases. Thus, the amplitude of the driving current to be output from the modulation control portion 1511 increases.

The MPU 850 initially turns on the analog switch 1613. If the aged deterioration of the light emitting device 112 is detected, the MPU 850 reduces the level of the driving current (increasing the extinction ratio) by increasing the resistance value of the digital variable resistor 820 and reduces the amplitude of the driving current by turning off the analog switch 1613. Therefore, the extinction ratio can be kept constant even by reducing the output light level of the light emitting device 112.

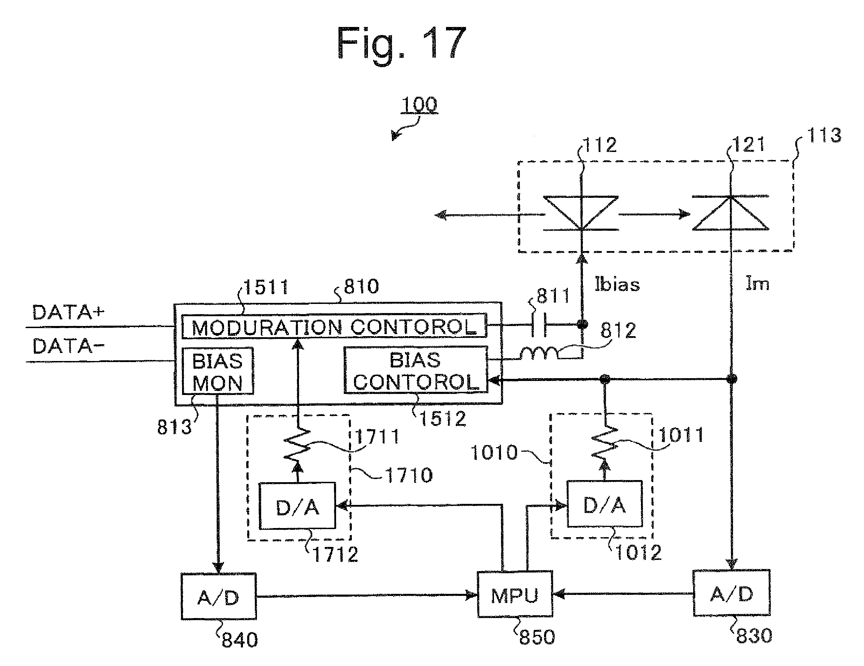

Fig. 17 is a block diagram showing Variation Example 2 of the optical transmitter shown in Fig. 15. In Fig. 17, the same reference numerals are given to the same components as the components shown in Fig. 10 or 15, and the description thereon will be omitted herein. As shown in Fig. 17, the optical transmitter 100 according to Embodiment 6 may include a D/A converting portion 1010 (refer to Fig. 10) and a D/A converting portion 1710 instead of the digital variable resistor 820 and digital variable resistor 1520 shown in Fig. 15.

The D/A converting portion 1710 includes a resistor 1711 and a D/A converter 1712. The resistor 1710 has one end connecting to the modulation control portion 1511 and the other end grounded. The D/A converter 1012 has the digital side connecting to the MPU 850 and the analog side connecting to the resistor 1011. The set voltage in the D/A converter 1712 is set by the MPU 850.

As the set voltage in the D/A converter 1712 set by the MPU 850 increases, the amplitude of the driving current to be output from the modulation control portion 1511 decreases, and the extinction ratio of the output light by the light emitting device 112 decreases. As the set voltage in the D/A converter 1712 set by the MPU 850 decreases, the amplitude of the driving current to be output from the modulation control portion 1511 increases, and the extinction ratio of the output light by the light emitting device 112 increases.

The MPU 850 initially sets lower set voltage in the D/A converter 1012. If the aged deterioration of the light emitting device 112 is detected, the MPU 850 reduces the level of the driving current (increasing the extinction ratio) by increasing the set voltage in the D/A converter 1012 and reduces the amplitude of the driving current by increasing the set voltage in the D/A converter 1712. More specifically, the MPU 850 controls to maintain the ratio of the set voltage in the D/A converter 1012 and the D/A converter 1712. Therefore, the extinction ratio can be kept constant even by reducing the output light level of the light emitting device 112.

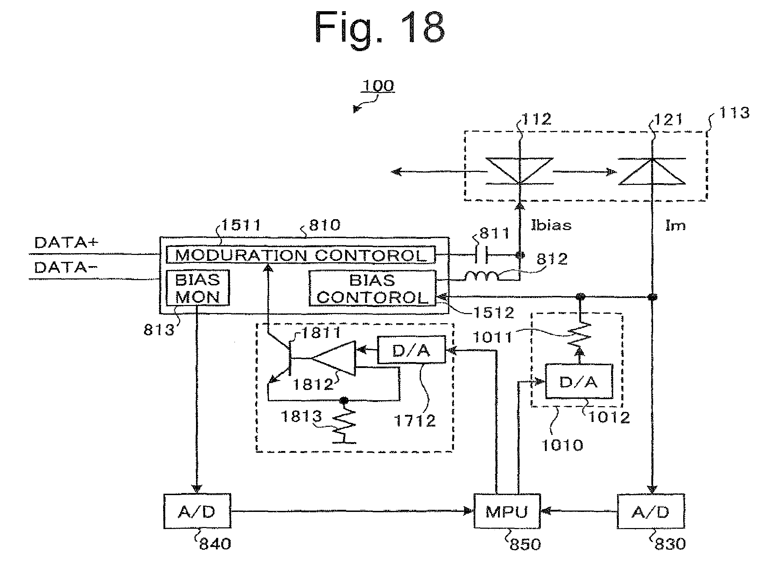

Fig. 18 is a block diagram sowing Variation Example 3 of the optical transmitter shown in Fig. 15. In Fig. 18, the same reference numerals are given to the same components as the components shown in Fig. 17, and the description thereon will be omitted herein. As shown in Fig. 18, the optical transmitter 100 according to Embodiment 6 may include a transistor 1811 and an operational amplifier 1812 instead of the D/A converting portion 1710 shown in Fig. 17.

The collector of the transistor 1811 connects to the modulation control portion 1511. The emitter of the transistor 1811 connects to the common-mode input terminal of the operational amplifier 1812. The base of the transistor 1811 connects to the output terminal of the operational amplifier 1812. A resistor 1813 connects to the common-mode input terminal of the operational amplifier 1812. The analog side of the D/A converter 1712 connects to the opposite-mode input terminal of the operational amplifier 1812.

As the set voltage in the D/A converter 1712 set by the MPU 850 increases, the amplitude of the driving current to be output from the modulation control portion 1511 increases. As the set voltage in the D/A converter 1712 set by the MPU 850 deceases, the amplitude of the driving current to be output from the modulation control portion 1511 decreases.

The MPU 850 initially sets higher set voltage in the D/A converter 1012. If the aged deterioration of the light emitting device 112 is detected, the MPU 850 reduces the level of the driving current by increasing the set voltage in the D/A converter 1012 and reduces the amplitude of the driving current by decreasing the set voltage in the D/A converter 1712. More specifically, the MPU 850 controls to maintain the ratio of the set voltage in the D/A converter 1012 and the D/A converter 1712. Therefore, the extinction ratio can be kept constant even by reducing the output light level of the light emitting device 112.

In this way, the optical transmitter 100 according to Embodiment 6 can keep the extinction ratio of the output light by the light emitting device 112 constant even by reducing the set value for the feedback control over the output level of the light emitting device 112, like the optical transmitter 100 according to Embodiment 5. Therefore, even though the light emitting device 112 is aged, deteriorated, the deterioration in the transmission characteristic can be suppressed for the operation.

As described above, according to the disclosed optical transmitter and control method, the aged deterioration of a light emitting device can be detected. Regarding the aforesaid embodiments, following appendices will be further disclosed.

As described the embodiments, the disclosed optical transmitter and control method provide advantages that the aged deterioration of a light emitting device can be detected and that an increase in power consumption of the optical transmitter can be suppressed.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

**Claims**

1. A optical transmitter comprising:

   a light emitting device being provided a driving current and for emitting light on the bases of the driving current;
   a light measure for measuring an output light power level of the light emitting device;
   a controller for controlling the driving current to the light emitting device in order to change the measured output light power level into a set output light power level of the light emitting device;
   a current measure for measuring a level of the driving current to the light emitting device;
   an abnormality detector for detecting an aged deterioration of the light emitting device on the bases of the current level of the driving current by the current measure and the measured output light power level by the light measure; and
   an adjuster for reducing the set output light power level in the controller when the abnormality detector detects the aged deterioration of the light emitting device.

2. The optical transmitter of claim 1, wherein:

   the abnormality detector detects an abnormally state of the optical transmitter; and
   the adjuster turns off light of the light emitting device when the abnormality detector detects the abnormally state.

3. The optical transmitter of claim 1, wherein the abnormality detector determines the aged deterioration when the level of the driving current is lager than a predetermined current threshold level and the output light power is normal level.

4. The optical transmitter of claim 2, wherein the abnormality detector determines the abnormally state of the optical transmitter when the level of the driving current is lager than a predetermined current threshold level and the output light power is lager than a predetermined output light power level.

5. The optical transmitter of claim 2, wherein the abnormality detector determines in damage of the light emitting device when the level of the driving current is lager than a predetermined current threshold level and the output light power is zero.

6. The optical transmitter of claim 1,
   further comprising temperature sensor for detecting a temperature of the light emitting device;

wherein the abnormality detector for changes the driving current threshold level on the bases of the temperature of the light emitting device.

7. The optical transmitter of claim 2, further comprising a notifying portion for notifying a user of abnormally state type from the abnormality detector.

8. The optical transmitter of claim 1, wherein the adjuster counts number of times of the detected aged deterioration, and changes the predetermined current threshold level on the bases of the number of times of the detected aged deterioration.

9. The optical transmitter of claim 1, further comprising an extinction ratio adjuster for maintaining an extinction ratio of the output light from the light emitting device when the adjuster reduces the set output light power level in the controller.

10. The optical transmitter of claim 1, further comprising an extinction ratio adjuster for maintaining amplitude of the driving current, and for maintaining an extinction ratio of the output light from the light emitting device when the adjuster reduces the set output light power level in the controller.

11. A method for controlling a light emitting device being provided a driving current and for emitting light on the bases of the driving current, the method comprising:

> measuring an output light power level of the light emitting device;
> controlling the driving current to the light emitting device in order to change the measured output light power level into a set output light power level of the light emitting device;
> measuring a level of the driving current to the light emitting device;
> detecting an aged deterioration of the light emitting device on the bases of the current level of the driving current by the current measure and the measured output light power level by the light measure; and
> reducing the set output light power level in the controller when the abnormality detector detects the aged deterioration of the light emitting device.

# Fig. 1

# Fig. 2

OUTPUT LIGHT POWER [W]

EP 2 093 849 A2

# Fig. 3

EP 2 093 849 A2

# Fig. 4

DRIVING CURRENT LEVEL[mA]

420

410

−40°C      +25°C      +85°C

TEMPERATUR

EP 2 093 849 A2

# Fig. 5

500

| Type of Abnormal Stats | Condition | | Specific Phenomena |
|---|---|---|---|
| | Driving Current Level | Output Light Level | |
| Damage of Light Emitting Device | High | None | Light emitting device is in short. |
| | High | None | Wire of light emitting device is in open. |
| | High | None | Anode of mPD element shorts out to ground. |
| | High | None | mPD element is damaged. |
| | High | None | Anode of mPD element is in open. |
| | High | None | Cathode of light emitting device is in open. |
| | High | None | Anode of light emitting device is in open. |
| | High | None | Cathode of light emitting device shorts out to power source. |
| Abnormal Circuit | High | High | LD driver is abnormal so as to short cathode in contact with ground. |
| | High | High | Back monitor is abnormal. |
| | None | None | |
| Aged Deterioration | High | Normal | Light emitting device is in deterioration. |

EP 2 093 849 A2

# Fig. 6

START

Obtain Driving Current Level and Output Light Level — S601

Driving Current Level > Current Threshold Level — S602

Yes → Output Light Level Change? — S603

No (from S602) → Driving Current Level and Output Light Level is Nearly Equal Zero 0? — S610

Output Light Level Change? Yes → Output Light Level > Light Threshold Level — S606

Output Light Level Change? No → Detect Aged Deterioration — S604

Turned Off ? — S611

Output Light Level > Light Threshold Level No → Detect Damage in the Light Emitting Device — S607

Output Light Level > Light Threshold Level Yes → Detect Circuit Abnormality — S609

Turned Off ? No → Yes

Detect Damage in the Light Emitting Device → Turn Off Light Emitting Device — S608

Detect Aged Deterioration → Reduces Set Value — S605

END

EP 2 093 849 A2

# Fig. 7

# Fig. 8

EP 2 093 849 A2

Fig. 9

# Fig. 10

EP 2 093 849 A2

# Fig. 11

# Fig. 12

EP 2 093 849 A2

# Fig. 13

START

Obtain Driving Current Level — S1301

Aged Deterioration Flag Fa=1 ? — S1302
- Yes → Reduction Flag Fb=1 ? — S1303
- No → Driving Current Level > Current Threshold Level — S1309

Reduction Flag Fb=1 ? — S1303
- Yes → Stable ? — S1304
- No → Driving Current Level > Current Threshold Level — S1306

Stable ? — S1304
- Yes → Reduction Flag Fb=1 — S1305
- No

Driving Current Level > Current Threshold Level — S1306
- Yes → Reduction Flag Fb=1 — S1307
- No

Driving Current Level > Current Threshold Level — S1309
- Yes → Aged Deterioration Flag Fa=1 — S1310
- No → END

Aged Deterioration Flag Fa=1 — S1310
- No

Reduction Flag Fb=1 — S1307

Count of the Number of Times n=n+1 — S1308

END

EP 2 093 849 A2

# Fig. 14

EP 2 093 849 A2

# Fig. 15

EP 2 093 849 A2

# Fig. 16

EP 2 093 849 A2

# Fig. 17

# Fig. 18

EP 2 093 849 A2

## Fig. 19

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007194576 A

- JP 2003218460 A